# DEMANDE DE BREVET EUROPEEN

(11) **EP 1 462 968 A2**
(43) Date de publication de la demande: **29.09.2004**
(21) Numéro de dépôt: 04300162.7
(22) Date de dépôt: 24.03.2004
(51) Int. Cl.: G06F 17/50

(54) **Procédé et dispositif pour dimensionner un circuit électrique**

(30) Priorité: 28.03.2003 FR 0303829
(71) Demandeur: Renault s.a.s., 92100 Boulogne Billancourt (FR)
(72) Inventeur: Gaillard, Jérôme, 75015 Paris (FR); Tonnerieux, François, 92160 Antony (FR)

(57) **Abrégé**

La présente invention concerne un procédé de dimensionnement électrique d'un schéma électrique comportant au moins une force électrique et au moins un circuit de composant électrique reliés par des conducteurs et, le cas échéant, protégés par des dispositifs de protection électrique.

L'invention concerne aussi un outil informatique de dimensionnement (ODE) mettant en oeuvre le procédé de l'invention.

Le procédé de l'invention propose une succession de phases de dimensionnement permettant de réaliser un dimensionnement des conducteurs (FRD), notamment des sections de fils, ainsi que des calibres des fusibles de protection pour chacun des circuits du schéma complexe dont le dimensionnement est réalisé à l'aide de l'outil de dimensionnement (ODE).

## Description

La présente invention concerne un procédé de dimensionnement électrique d'un schéma électrique comportant au moins une source d'énergie électrique et au moins un circuit de composants électriques reliés par des conducteurs et protégés par des dispositifs de protection électrique.

L'invention concerne aussi un outil informatique de dimensionnement électrique mettant en oeuvre le procédé de l'invention.

Dans le domaine du câblage de grands ensembles électriques comme on en trouve sur un véhicule automobile, il est apparu un besoin d'aide automatique à la conception des schémas électriques. Or, si des réalisations sont apparues depuis l'émergence de ce besoin, elles répondent à des demandes venant de métiers homogènes. Cependant, dans de tels ensembles en effet, les sous-systèmes ou circuits électriques sont conçus par des concepteurs différents et souvent à des moments différents, particulièrement quand le concepteur souhaite reprendre dans un nouveau schéma de câblage un circuit électrique provenant d'un développement précédent. Il en résulte que le dimensionnement d'ensemble est mené sur la base de résultats de dimensionnement partiels sans permettre de tenir compte d'un objectif de résultats de dimensionnement d'ensemble.

Dans le document "Computer-aided design and simulation of low voltage electrical distribution systems", Teo C. Y., XP-004097813, ISSN-0166-3615, un système est décrit dans lequel on apprend comment utiliser un logiciel de dessin assisté par ordinateur pour dresser des plans de câblage pour des immeubles. Mais le dimensionnement électrique n'est pas directement impliqué dans l'article.

C'est un objet de la présente invention de proposer une solution améliorée permettant de concevoir le câblage de schémas électriques de circuits électriques hétérogènes.

Dans le domaine de l'automobile, mais aussi dans d'autres domaines de l'industrie, la durée des dévoloppements d'un produit fini tend à se réduire de façon à répondre aux besoins du marché à temps quand des progrès sont réalisés même seulement sur une partie d'un véhicule.

C'est un autre objet de l'invention de proposer une solution permettant d'accélérer le développement d'un schéma électrique comme on en trouve sur un véhicule automobile.

Le coût du câblage est une contrainte que devient de plus en plus importante avec l'augmentation du nombre de circuits électriques dans un ensemble électrique comme on en trouve sur un véhicule automobile. Cette contrainte de coût est augmentée notamment par la longueur et donc par la topologie des conducteurs qui sont utilisés pour réaliser les différents circuits électriques du schéma en cours d'élaboration. Or, pour optimiser la conception d'un schéma, il faut pouvoir reprendre la conception de certains circuits électriques lors de la phase d'élaboration du schéma. Ceci n'est pas facilement réalisable par les outils de CAO actuellement disponibles parce qu'ils ne permettent pas de fédérer les différents développements des divers circuits lors de cette étape finale de développement d'un ensemble électrique comme on en trouve sur un véhicule automobile.

C'est un autre objet de l'invention de proposer une solution permettant de concevoir de manière optimale le schéma d'un ensemble électrique comme on en trouve sur un véhicule automobile.

Dans l'état de la technique, il est connu de dimensionner manuellement en fonction de règles de métier les sections des fils conducteurs ainsi que les calibres des fusibles qui sont disposés pour protéger les circuits qui sont conçus indépendamment.

Pour permettre d'optimiser l'application d'une telle règle de métier, d'une part, et de réduire le coût du câblage, d'autre part, ainsi que d'accélérer la phase de conception du schéma électrique adaptée à un véhicule, la présente invention propose un procédé automatisé permettant de parvenir à une solution optimale.

C'est un avantage du procédé de l'invention de rendre homogène le dimensionnement du câblage des schémas électriques dans un véhicule.

En effet, le procédé de l'invention permet de faire travailler de manière homogène les différentes équipes qui conçoivent les différente circuits électriques utilisés dans le véhicule.

Un autre avantage du procédé de l'invention est de permettre des dimensionnement de schémas électriques sur de larges périmètres incluant l'ensemble du véhicule à la limite.

On évite ainsi de réaliser un dimensionnement fil à fil ou encore fonction par fonction qui ne permet jamais d'atteindre une optimalisation sous contrainte de la fonction de câblage dans le véhiculé.

Un autre avantage de l'invention est, dans la phase de dimensionnement du schéma électrique, de permettre d'utiliser les valeurs calculées par un simulateur de comportements électriques des composants des circuits électriques constituant le schéma. Le procédé de l'invention ne dépend pas du type de simulateur et, au contraire, est adapté à tous types de simulateurs en fonction de format de données d'échange.

Un autre avantage de la présente invention est de permettre de s'adapter à l'accroissement du nombre des fonctions électriques dans le véhicule et de permettre d'optimiser les sections de fil et donc le volume des câbles, leur poids, ainsi que le prix de revient.

Pour atteindre ces objets, le procédé de l'invention se caractérise essentiellement en ce qu'il consiste à réaliser un dimensionnement des paramètres des conducteurs et des calibres des dispositifs de protection des circuits électriques du schéma en cours de dimensionnement sur la base de contraintes électriques imposées par les trois phase successives suivantes :
- dimensionnement en fonctionnement nominal du schéma électrique ;
- dimensionnement en vérification en court-circuit des composants des circuits du schéma électrique; et
- dimensionnement en test du respect de conditions de fonctionnement en chute de tension.

La présente invention fournit un outil de dimensionnement électrique mettant en oeuvre le procédé de l'invention se caractérise essentiellement en ce qu'il comporte un moteur de dimensionnement mettant en oeuvre une procédure de dimensionnement définie selon le procédé de l'invention et sur la base de données issues d'un outil de modélisation des circuits électriques et produisant un fichier de résultats de dimensionnement du schéma électrique composé des circuits électriques.

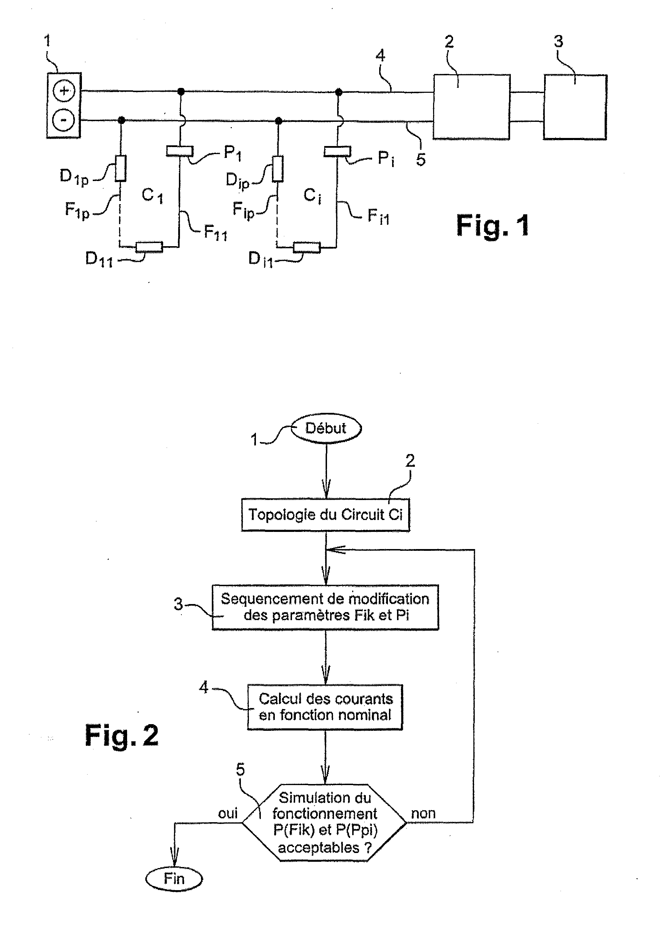

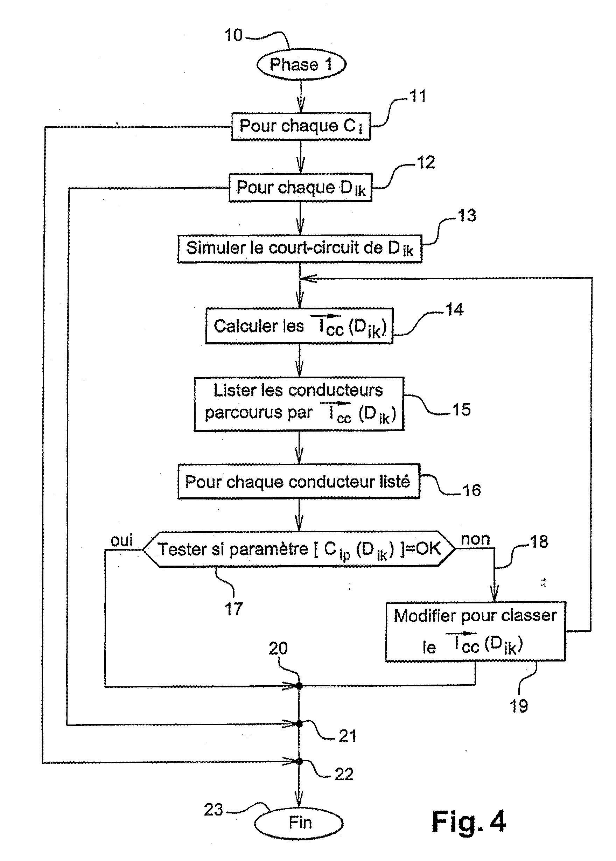

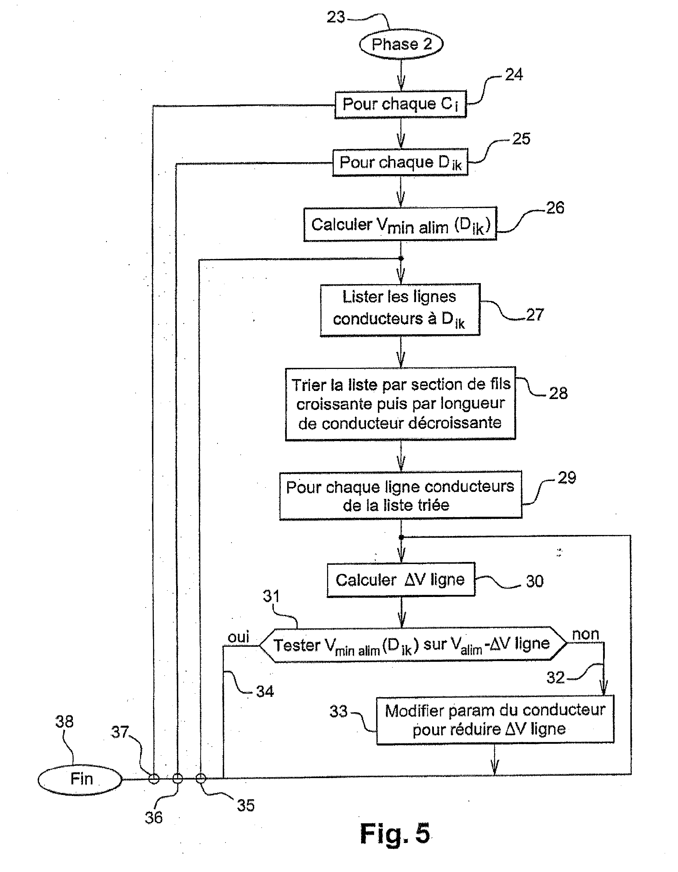

La présente invention fournit aussi un article de commerce comportant une mémoire lisible par un ordinateur, un programme exécutable par un ordinateur étant enregistré sur ladite mémoire pour le dimensionnement électrique d'un schéma électrique comportant au moins une source électrique et au moins un circuit électrique (Ci) de composants (Dik) reliés par des conducteurs (Fik) et, le cas échéant, protégés par des dispositifs de protection électrique (Di), caractérisé en ce que ledit programme inclut un codage pour réaliser un dimensionnement des paramètres des conducteurs et des calibres des dispositifs de protection des circuits électriques (Ci) du schéma en cours de dimensionnement sur la base de contraintes électriques imposées successivement selon les phases suivantes:
- un dimensionnement en fonctionnement nominal du schéma électrique (Figure 2) ;
- un dimensionnement en vérification en court-circuit des composants des circuits du schéma électrique (Figure 4) ;
   un dimensionnement en test du respect de conditions de fonctionnement en chute de tension (Figure 5), et
- une phase d'enregistrement, de préférence sur un dispositif lisible par un ordinateur, du dimensionnement ainsi obtenu des paramètres des conducteurs et des calibres des dispositifs de protection des circuits électriques (Ci) du schéma en cours de dimensionnement.

D'autres caractéristiques et avantages de la présente invention apparaîtront à l'aide de la description des figures parmi lesquelles :
- la figure 1 représente un ensemble de schémas électriques dont le dimensionnement est réalisé à l'aide du procédé de l'invention
- la figure 2 représente un organigramme d'une première phase du procédé de l'invention ;
- la figure 3 représente un schéma de principe d'un outil de dimensionnement électrique mettant en oeuvre le procédé de l'invention;
- la figure 4 représente une seconde phase du procédé de dimensionnement de l'invention; et
- la figure 5 représente une troisième phase de dimensionnement selon le procédé de l'invention.

A la figure 1, on a représenté un exemple de schéma électrique adapté à un véhicule, le schéma électrique étant conçu dans le but d'être dimensionné à l'aide du procédé de l'invention avec l'outil de l'invention.

Dans un domaine d'application aux courants continus, le schéma électrique représente un ensemble de circuits électriques destinés à être connectés à une batterie électrique 1, source de tension continue, qui présente deux polarités et qui est connectée par un fil ou conducteur 4 à une première borne d'une régulateur 2 qui est connecté lui-même à un alternateur 3. Un conducteur 5 relie une autre borne du régulateur à la borne négative et/ou au châssis du véhicule.

Dans cette configuration d'alimentation bipolaire, le schéma électrique regroupe une pluralité de circuits électriques C1, C2, ..., Ci en nombre déterminé lors de la conception du véhicule.

Chaque circuit Ci est connecté, d'une part, au conducteur d'alimentation positive 4 et, d'autre part, au conducteur d'alimentation négative 5 et/ou au châssis du véhicule. Dans ce qui suit, le premier index réfère au numéro du circuit dans le schéma électrique auquel il appartient et le second index réfère à l'objet du circuit, composant, conducteur ou dispositif de protection dont il compose l'étiquette. Chaque circuit Ci est constitué par une pluralité de composants Di1, ..., Dip, ... qui sont reliés entre eux dans le circuit électrique Ci par des conducteurs Fi1, Fi2.... Fip. De plus, chaque circuit Ci est doté de dispositifs de protection électrique comme le dispositif Pi, généralement connecté sur la ligne positive d'alimentation du circuit protégé.

Les conducteurs Fip sont caractérisés par des paramètres électriques, par exemple quand ils sont réalisés sous forme de fils conducteurs, comme la section du fil, sa résistivité, ainsi que sa longueur. Dans d'autres modes de réalisation, les conducteurs peuvent être réalisés sous forme de tresses, ou de plaques. Plus généralement, ils servent à transporter de l'énergie de sorte qu'un courant électrique continu soit échangé entre une borne centrée et une borne de sortie sous l'effet de la source de tension ou de courant continue.

De même, chaque composant électrique Dip est caractérisé par des paramètres de fonctionnement comprenant notamment une valeur de courant maximum admissible en court-circuit lcc(Dip), la tension d'alimentation minimale de fonctionnement hors défaut Vmin(Dip), ainsi que des paramètres électriques de fonctionnement nominal.

De même, chaque dispositif de protection comme le dispositif Pi est caractérisé par des paramètres électriques comme le courant maximum admissible Imax, ou d'autres paramètres comme le temps de fusion en fonction du courant traversant. Particulièrement, dans le cas où le dispositif de protection Pi comporte des fusibles, chaque fusible est caractérisé par un courant de fusion. Dans d'autres modes de réalisation, un dispositif de protection peut comporter plusieurs composants semi-conducteurs comme un SmartPower™ ou encore des dispositifs comme des fusibles réarmables sous l'effet de leur refroidissement ou d'un autre phénomène physique.

Selon l'invention, un tel schéma électrique pré existe au moins lors de l'initialisation du procédé de l'invention. Un tel schéma peut être établi entièrement sans le secours de l'invention. Chaque circuit peut être conçu avec des contraintes tenant compte des caractéristiques d'ensemble du schéma électrique comme des critères de consommation ou de coût de câblage par une équipe de concepteurs indépendants des autres équipes qui traitent d'autres circuits. Ce sera le cas des circuits électriques réservés à la fonction d'éclairage du véhicule ou des circuits électriques réservés à l'essuyage.

Lors de la procédure d'initialisation de l'invention, la caractérisation du schéma électrique est entièrement notée sous forme de listes décrivant d'une part les caractéristiques topologiques principalement des conducteurs constituant les divers circuits Ci et d'autre part les caractéristiques électriques indiquées à titre d'exemple ci-dessus.

Lorsque le procédé de l'invention a été exécuté au moins une fois, au moins les caractéristiques électriques d'au moins un circuit électrique Ci du schéma électrique peuvent être redimensionnées pour permettre une optimisation de critères de fonctionnement du câblage sur une base d'ensemble du schéma électrique.

Il est dans un mode de réalisation préféré, possible alors de réaliser la conception d'une forme modifiée de schéma électrique à l'aide d'outils traditionnels de Conception assistée par Ordinateur ou autrement, et de soumettre à nouveau un schéma modifié à l'exécution du procédé de l'invention pour que soient prises en compte les règles de métier de façon à prendre en compte les nouvelles données caractérisant les sections des fils et les calibres des dispositifs de protection calculés dans cette exécution du procédé de dimensionnement de câblage.

A la figure 2, on a représenté une première phase de fonctionnement du procédé de l'invention qui concerne le dimensionnement en fonctionnement nominal du schéma électrique.

Le procédé de l'invention débute par une séquence d'initialisation 1 dans laquelle on réalise l'initialisation des différents paramètres de fonctionnement du procédé, et particulièrement le chargement des caractéristiques des éléments de circuits électriques et des caractéristiques électriques des différents circuits décrits à l'aide de la figure 1.

Les principales sous étapes de séquence d'initialisation 1 sont :
- Recherche des données et modèles manquants ;
- Recherche de la topologie de chaque circuit électrique du schéma ;
- Acquisition des données manquantes ;
- Acquisition des paramètres de dimensionnement.

Brièvement, la première phase du procédé de l'invention comporte ensuite et successivement une étape 2 de détermination de la topologie d'un circuit Ci pris dans le schéma électrique en cours de dimensionnement, puis une boucle de calcul et de modifications des étapes 3 et 4 qui se termine par un test de fin de boucle 5 qui permet de déterminer si la simulation du fonctionnement du circuit Ci en cours de test de première phase est correct ou non. Dans le cas positif, une étape de fin est exécutée.

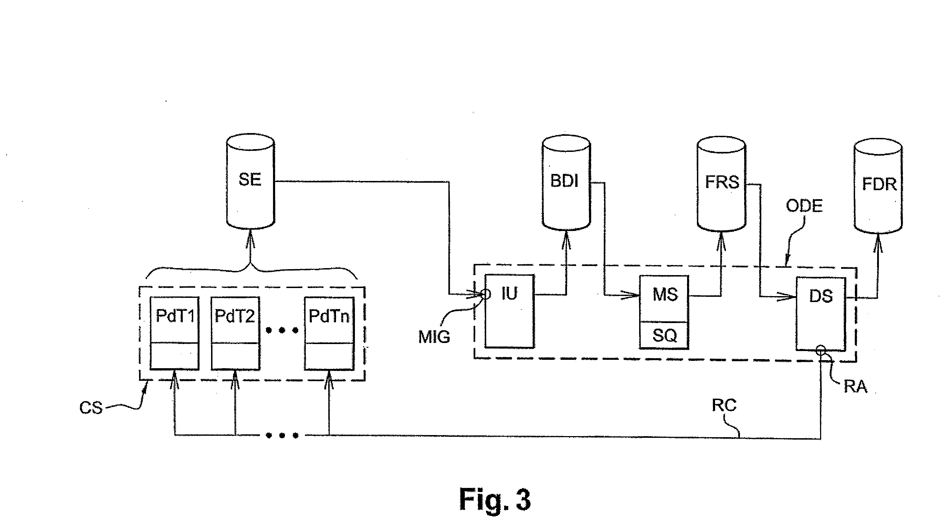

Pour permettre de suivre le procédé de l'invention, on va maintenant se référer à la figure 3 qui représente un mode de réalisation de l'outil de dimensionnement ODE de l'invention qui met en oeuvre le procédé de l'invention. L'outil de dimensionnement électrique ODE comporte trois grandes parties essentielles qui sont :
- un dispositif d'entrée IU qui traite les données initiales de la séquence d'initialisation 1 du procédé de l'invention qu'on vient de décrire ;
- un moteur de dimensionnement composé principalement d'un moteur de simulation MS d'événements électriques adapté au schéma électrique en cours de dimensionnement et un séquenceur SQ qui met en oeuvre les différentes étapes du procédé de l'invention ainsi qu'elles seront décrites ci-après ; et
- un dispositif de sortie DS.

Le dispositif d'entrée IU de l'outil ODE comporte des moyens pour réaliser la migration des données caractéristiques des circuits électriques calculées lors de la conception du schéma électrique dans une base de données BDI qui sera exploitée par la seconde partie de l'outil de dimensionnement ODE. Particulièrement, les moyens de migration MG comportent des moyens pour adresser des données, enregistrées dans une mémoire SE et représentatives des caractéristiques des topologies de circuits électriques et des caractéristiques électriques des différents circuits décrits à l'aide de la figure 1 pour un schéma électrique donné à dimensionner à l'aide de l'outil ODE.

L'interface utilisateur IU de l'outil de dimensionnement ODE est relié à une ou plusieurs consoles connectées sur un réseau de communications RL et comportant un ensemble composé d'un clavier, d'un périphérique de pointage et d'un écran qui permet d'effectuer les opérations des sous étapes de la séquence d'initialisation 1 du procédé de l'invention.

Une fois constituée la base de données initiales BDI lors de l'exécution de la séquence d'initialisation 1, celle-ci est exploitée par le moteur de dimensionnement précédemment évoqué. Le moteur de dimensionnement de l'outil de dimensionnement ODE comporte un séquenceur SQ qui exécute les étapes des trois phases du procédé de l'invention en utilisant un moteur de simulation MS qui sera décrit plus loin. Les données de la base de données initiales sont alors modifiées par le moteur de simulation MS en fonction de l'exécution du procédé de façon à générer un fichier de résultats de simulation du schéma électrique FRS qui est stocké dans une mémoire sous une structure déterminée permettant de classer les différentes données. Dans un mode de réalisation, le fichier de résultats de simulation FRS reprend la structure de la base de données initiales BDI.

Enfin l'outil de dimensionnement ODE comporte un dispositif de sortie DS pour produire un fichier de résultats de dimensionnement final FRD. Dans un mode particulier de réalisation, ce fichier de résultats de dimensionnement FRD comporte une liste de sections de conducteurs et de calibres des fusibles des circuits électriques du schéma électrique d'entrée.

Dans un mode de réalisation, le dispositif de sortie DS comporte un dispositif d'exploitation du fichier de résultats de simulation du schéma électrique et un dispositif de proposition de calcul à un utilisateur. Le dispositif d'exploitation du fichier de résultats de simulation du schéma électrique comporte une ressource de lecture des articles du fichier de résultats de simulation du schéma électrique en fonction des requêtes du dispositif de proposition de calcul à un utilisateur. Ce dispositif de proposition de calcul à un utilisateur comporte notamment une interface utilisateur qui permet à l'utilisateur d'accepter et/ou de rétro-annoter le fichier de résultats de dimensionnement.

Dans un mode de réalisation, le moteur de dimensionnement est automatisé sur la base d'un système expert intégrant les règles de métier que l'utilisateur prend en compte dans la version « manuelle ».

Dans un mode de réalisation, le dispositif de sortie DS comporte un moyen de rétro annotation RA qui retourne les données de dimensionnement final des conducteurs et des calibres d'au moins un circuit électrique du schéma électrique à destination de l'application logicielle et du poste de travail PdTi sur le réseau de communications qui a produit ou qui est en train de concevoir le circuit électrique Ci en question. On dispose ainsi d'un outil de dimensionnement qui travaille en boucle fermée avec les applications logicielles de CAO de conception des différents circuits électrique d'un schéma électrique donné. L'outil de dimensionnement électrique de l'invention, partie référencée ODE au dessin, constitue un sous-ensemble de l'application CAO, relié à l'ensemble des postes de travail, des applications logicielles de conception assistée par ordinateurs pour concevoir les circuits électriques et le schéma électrique qu'ils composent ainsi que le réseau de communications RC qui les relie.

En se reportant à nouveau à la Figure 2, lors d'une étape 2, le moteur de dimensionnement MS, SQ de l'outil ODE effectue une opération de dimensionnement en régime nominal. Le séquenceur SQ est programmé de façon à lancer cette opération dès la fin de la séquence d'initialisation 1 précédemment décrite. Lors de cette opération de dimensionnement en régime nominal, les fils et fusibles sont dimensionnés en fonction des courants circulants dans le circuit électrique en cours de dimensionnement dans son fonctionnement normal. Les valeurs obtenues sont les valeurs minimales acceptables pour que les fonctions électriques soient alimentées sans risque pour le câblage. La topologie de chaque circuit électrique comme le circuit Ci est déterminée sur la base des liaisons entre les composants Dip du circuit Ci, ainsi que des conducteurs Fip et des protections Pi.

Le contrôle passe à la boucle décrite précédemment et qui comporte d'abord une étape 3 qui permet de calculer en séquence les modifications programmées des paramètres des conducteurs F1k et des paramètre des dispositifs de protection Pi.

Lors de cette étape, on réalise une réduction progressive pas à pas de chacune des valeurs de chacun des paramètres des conducteurs Fik, ainsi que des outils de protection Pi jusqu'à atteindre une première valeur non acceptable. Puis, on réalise une augmentation pas à pas des valeurs non acceptables de façon à ce que ces valeurs deviennent acceptables en fonctionnement nominal.

Lors d'une étape 4, on réalise le calcul des courants circulants en fonctionnement nominal dans le circuit Ci. A cette fin, on peut utiliser des outils standard de simulation du fonctionnement d'un circuit électrique comme le circuit Ci, selon des contraintes reproduisant le mode de fonctionnement du schéma électrique dans un environnement réel, contraintes spécifiées à l'aide d'un outil de configuration de contraintes.

Enfin, on réalise un test 5 de simulation du dimensionnement à l'aide d'un outil de simulation et, si le test est correct, on passe à une étape de fin 10 au cours de laquelle les paramètres de dimensionnement issus de la première étape sont transmis, ou bien, si le test 5 est en défaut, le contrôle retourne au début de la boucle en fournissant une nouvelle valeur de modification des paramètres Fik et Pi.

Bien entendu, la première phase du procédé de l'invention est exécutée séquentiellement ou concurremment pour tout ou partie des circuits Ci du schéma électrique en cours de dimensionnement.

Le procédé de l'invention comporte ensuite une seconde phase qui a été illustrée à la figure 4 et qui consiste à réaliser le dimensionnement en court-circuit du circuit Ci du schéma électrique.

Dans cette phase, le moteur de dimensionnement MS, SQ de l'outil ODE effectue une opération de vérification du schéma électrique en situation de court-circuit. Le séquenceur SQ est programmé de façon à lancer cette opération dès la fin de la première phase proprement dite du procédé de l'invention décrite à l'aide de la Figure 2. Lors de cette opération de vérification en court-circuit, à partir d'une valeur minimale par défaut, les sections des fils sont augmentées de façon incrémentale de telle sorte que les fusibles protègent les fils lors de courts-circuits simulés par le moteur de simulation. D'une manière pratique, la conception du schéma électrique est vérifiée de sorte que les temps de fusion des fusibles ou, plus généralement, le temps de réaction des dispositifs de protection, soient inférieurs aux temps de fusion des fils qu'ils protègent. Le moteur de dimensionnement MS comporte des moyens pour exploiter la topologie de chaque circuit de façon à pouvoir associer chaque conducteur à un fusible lors du test de simulation en court-circuit.

A l'issue normale 10 de l'étape décrite à l'aide de la figure 2, on réalise une première boucle de contrôle 11 qui pour chaque circuit va établir un dimensionnement en simulant le court-circuit.

Lors d'une boucle 12, pour chaque composant Dik du circuit Ci, on réalise la simulation du court-circuit du composant Dik lors d'une étape 13.

Lors d'une étape 14, dans l'état de court-circuit du composant Dik, on réalise le calcul d'une liste des courants de court-circuit qui traverse le composant Dik.

Quand le composant Dik est un dipôle, le courant de court-circuit est constitué par une valeur unique.

On réalise ensuite, lors d'une étape 15, la liste des conducteurs qui sont parcourus par les courants de la liste établie à l'aide de l'étape 14.

Le contrôle passe ensuite à une boucle 16 sur chacun des conducteurs listés dans la liste produite à l'aide de l'étape 15.

On réalise alors pour chaque conducteur de cette liste un test pour savoir si les paramètres de ce conducteur permettent de tenir les caractéristiques en courant de court-circuit.

Si, lors de la sortie 18 pour un composant Dik et pour un fil Fik correspondant, un défaut apparaît dans le test, lors de l'étape 19, on compare le courant qui traverse le fil Fik avec le courant ou le paramètre de claquage ou de déclenchement du dispositif de protection Pi qui lui est associé.

Si ces valeurs ne se correspondent pas, une modification des paramètres du conducteur, essentiellement la section d'un fil, est exécutée jusqu'à permettre le dimensionnement convenable du conducteur.

Tant que l'étape 19 de modification ne permet pas d'obtenir un test 17 positif, le contrôle retourne à la séquence de tests 14-15-16-17-18.

On trouve ainsi successivement les détections de fin de boucle 20 pour la boucle initiée à l'étape 16, 21 pour la boucle initiée à l'étape 12 et, 22 à la boucle initiée à l'étape 11, et on passe à la dernière boucle à l'étape de fin 23.

Le procédé de l'invention comporte enfin une troisième phase illustrée à la figure 5. Au cours de cette troisième phase, le moteur de dimensionnement MS, SQ de l'outil ODE effectue une opération de vérification du respect de la chute de tension. Le séquenceur SQ est programmé de façon à lancer cette opération dès la fin de l'étape de vérification en court-circuit précédemment décrite. Lors de cette opération de respect de la chute de tension du procédé de l'invention, on vérifie les contraintes de tension minimale.

A la fin de l'étape 23 de la troisième phase du procédé de l'invention, on initialise une première boucle 24 pour chaque circuit Ci.

Le contrôle passe ensuite à l'initialisation d'une seconde boucle 25 qui permet de lister chacun des composants Dik du circuit Ci.

Lors d'une étape 26, on identifie la tension minimale d'alimentation du composant Dik en cours d'analyse.

Puis, lors d'une étape 27, on réalise la liste des conducteurs qui parviennent au composant Dik.

Lors d'une étape 28, on réalise ensuite le tri de cette liste de conducteur par section de fils croissants puis par longueur de conducteurs décroissante.

Dans ce tri à deux clefs, on permet ainsi un schéma d'optimisation qui a démontré sa validité lors d'essais.

Lors d'une étape 29, on initie une boucle sur la liste triée.

Pour la somme des conducteurs de cette liste, lors d'une étape 30, on réalise le calcul de la chute de tension que cette ligne apporte.

Puis, on réalise le test pour savoir si la tension minimum d'alimentation sur le composant est garantie avec la chute de tension calculée lors de l'étape 30.

Si le test 31 est, par sa sortie 32, négatif, lors d'une sous étape 33, on réalise une sous étape de modification des paramètres d'un conducteur destinés à réduire d'un pas déterminé la chute de tension qu'il introduit.

Le contrôle retourne alors à l'étape 30 de calcul de la chute de tension.

Quand le test est positif, à la sortie 34, le contrôle passe au test de fin de première boucle 35 de façon à retourner en haut de boucle 27, puis au test de fin de boucle 36 initié par la sous étape 25, et le contrôle parvient enfin à l'étape de fin 38 à l'issue de laquelle le procédé de l'invention permet d'obtenir les paramètres des conducteurs ainsi que des protections optimisées pour le schéma électrique de la topologie déterminé à l'entrée.

Diverses dispositions sont encore possibles dans le cadre de l'invention. Particulièrement, le moteur de simulation (MS) comporte des moyens pour calculer la valeur de tension, le courant et la température en un point du circuit électrique Ci qui lui est communiqué sur la base de données validées par l'utilisateur à l'aide du dispositif d'entrée IU. A cet effet, l'utilisateur dispose d'un fichier dit de « nomenclature électrique » qui contient la définition des composants des circuits Ci du schéma électrique dont on dimensionne les paramètres. Dans une étape préalable de réglage et d'intervention de l'utilisateur, une adaptation de la nomenclature électrique est exécutée en particulier en indiquant les paramètres manquants issus de la topologie générée.

L'utilisateur dispose ensuite d'un fichier des contraintes électriques et des paramètres de fonctionnement, notamment du fonctionnement nominal, du fonctionnement en court-circuit et du fonctionnement de la tension d'alimentation minimale.

A cet effet, le dispositif d'entrée IU dispose d'un canal de communication avec le fichier des contraintes qui est connecté par un canal au moteur de dimensionnement SQ, MD.

Par ailleurs, le moteur de dimensionnement SQ, MD comporte des moyens de connexion avec les dispositifs de CAO qui permettent de générer la topologie des circuits électriques du schéma en dimensionnement.

Le moteur de dimensionnement SQ, MD comporte, de plus, des moyens permettant de réaliser de manière autonome la simulation nécessaire à l'exécution du procédé de l'invention. A cet effet, le moteur de dimensionnement SQ, MD comporte des moyens de traitement par lots (traitement batch) qui sont connectés par un canal de communication avec le séquenceur SQ qui permet de réaliser chacune des étapes du procédé de l'invention.

Grâce à cette séparation du simulateur de la console d'interface homme/machine, l'utilisateur peut réaliser d'autres opérations pendant que le moteur de dimensionnement MS, SQ exécute le traitement par lots.

Particulièrement, on notera que le moteur de dimensionnement SQ, MD dispose de canaux d'accès direct à la nomenclature électrique, d'une part, ainsi qu'aux dispositifs de CAO de conception des circuits, d'autre part. De cette manière, il peut relancer, ainsi qu'on l'a décrit, les différents dimensionnements en mode automatique.

De façon à faciliter le travail de l'utilisateur, il est prévu un système de gestion de bases de données qui maintient des bases de données sur les composants électriques de chacun des circuits de la nomenclature électrique ainsi que des conducteurs F et des dispositifs de protection P.

Dans de telles bases de données, on va retrouver les paramètres ou, plus exactement, les gammes de valeurs des paramètres tant des composants électriques que des conducteurs et des dispositifs de protection. Le système de gestion de base de données permet d'adapter la base de données à des produits nouveaux ou à des références nouvelles.

Particulièrement, le système de gestion de bases de données permet de classer les protections à l'intérieur en les caractérisant par des calibres et par des types par rapport aux données d'un cahier des charges déterminé.

On dispose ainsi de gammes « enveloppe de protection » des fusibles qui permettent d'utiliser n'importe quelle référence de fusible correspondant ou répondant à cette gamme de valeurs.

La base de données de définition des conducteurs est gérée par le moteur de dimensionnement SQ, MD de façon à s'assurer que l'on dispose du modèle correct de conducteur à proposer au choix du séquenceur SQ.

Le système de gestion de base de données maintient un fichier des composants qui mémorise essentiellement les courants consommés en fonctionnement nominal, en fonctionnement de pointe, ou en fonctionnement dégradé.

De même, les tensions minimales d'alimentation sont enregistrées dans le fichier des composants maintenu par le système de gestion de bases de données.

Les informations pour chaque composant contenues dans le fichier des définitions des composants sont aussi utilisées pour réaliser l'identification du modèle du composant associé.

Le système de gestion de bases de données maintient un fichier des longueurs de fils. Les longueurs de fils enregistrées dépendent du parcours du câblage imposé par l'outil de CAO de conception des circuits Ci du schéma électrique.

Le moteur de dimensionnement SQ, MD comporte des moyens permettant de modifier les paramètres des conducteurs et des protections pendant les calculs sans intervention de l'utilisateur. A cette fin, le moteur de dimensionnement SQ, MD peut communiquer avec les bases de données de définition des protections Pi et des conducteurs Fik.

Le moteur de dimensionnement SQ, MD produit ensuite des résultats de simulation sous la forme de liste des paramètres dimensionnés des différents conducteurs pour chacun des circuits électriques de la nomenclature électrique ainsi que des paramètres de protection des dispositifs de protection Pi disposés dans ces circuits Ci. A cet effet, le moteur de dimensionnement SQ, MD comporte une voie d'écriture avec le dispositif de sortie DS.

Comme lors de l'étude du schéma électrique complet d'un véhicule, les circuits électriques sont destinés à évoluer et il faut s'assurer de la correspondance entre les schémas utilisés et le dimensionnement associé.

A cette fin, le fichier de résultats de dimensionnement final FRD est connecté à une base de données de schémas dimensionnés gérée par le système de gestion de bases de données. Le système de gestion de bases de données permet de disposer à tout moment d'une étude de dimensionnement qui peut servir d'état initial à une simulation relancée par le dispositif d'entrée DE. De même, le système de gestion de base de données permet de réaliser une sélection de dimensionnements en fonction de contraintes de fonctionnement qui sont gérées directement par le système de gestion de façon à permettre la sélection selon des contraintes de sélection déterminées pour un schéma électrique de dimensionnement correspondant.

De même, le fichier de résultats de dimensionnement FRD peut être connecté en lecture par un canal avec un dispositif de rétro annotation RA qui est connecté, d'une part, par une voie de bouclage au moteur de dimensionnement SQ, MD et, d'autre part, à l'outil de CAO PdTi pour modifier automatiquement les paramètres du schéma.

Il est ainsi possible de réaliser une optimisation sur la base de résultats de dimensionnement électrique pour l'ensemble du schéma électrique.

Le procédé de l'invention peut être programmé sur un article de commerce comportant une mémoire lisible par un ordinateur, par exemple un CD, DVD ou équivalent ou sur le disque dur d'un ordinateur. Un tel programme pour le procédé sera exécutable par un ordinateur, et sera enregistré sur ladite mémoire pour être exécuté par ledit ordinateur.

## Revendications

1. Outil de dimensionnement électrique d'un schéma électrique, ledit schéma comportant au moins une source électrique et au moins un circuit électrique (Ci) de composants (Dik) reliés par des conducteurs (Fik) et, le cas échéant, protégés par des dispositifs de protection électrique (Di), **caractérisé en ce que**, pour réaliser un dimensionnement des paramètres des conducteurs et des calibres des dispositifs de protection des circuit électriques (Ci) du schéma en cours de dimensionnement sur la base de contraintes électriques imposées successivement selon trois phases :
- un dimensionnement en fonctionnement nominal du schéma électrique (Figure 2) ;
- un dimensionnement en vérification en court-circuit des composants des circuits du schéma électrique (Figure 4) ; et/ou
un dimensionnement en test du respect de conditions de fonctionnement en chute de tension (Figure 5),
l'outil de dimensionnement comporte :
- un dispositif d'entrés (IU) qui traite des données initiales (1) ;
- un outil de modélisation de circuits électriques et
- un moteur de dimensionnement (MD, SQ) sur la base de données (BDI) et produisant un fichier de résultats de dimensionnement (FRD) du schéma électrique.

2. Outil selon la revendication précédente, **caractérisé en ce que** le moteur de dimensionnement (MD, SQ) comporte :
- un moteur de simulation (MS) d'événements électriques adapté au schéma électrique en cours de dimensionnement ;
- un séquenceur (SQ) qui est doté de moyens pour exécuter :
- un dimensionnement en fonctionnement nominal du schéma électrique (Figure 2) ;
- un dimensionnement en vérification en court-circuit des composants des circuits du schéma électrique (Figure 4) ; et/ou
- un dimensionnement en test du respect de conditions de fonctionnement en chute de tension (Figure 5).
et **en ce qu'**il coopère avec un dispositif de sortie (DS).

3. Outil selon la revendication 1 ou 2, **caractérisé en ce que**
pour réaliser la première phase qui comporte une séquence d'initialisation (1) préalable de migration des données caractéristiques des circuits électriques calculées lors de la conception du schéma électrique et qui est complétée par des opérations suivantes :
• Recherche des données et modèles manquants ;
• Recherche de la topologie de chaque circuit électrique du schéma ;
• Acquisition des données manquantes ;
• Acquisition des paramètres de dimensionnement ;
le dispositif d'entrée (IU) de l'outil (ODE) comporte des moyens pour réaliser la migration des données caractéristiques des circuits électriques calculées lors de la conception du schéma électrique dans une base de données (BDI), qui comportent des moyens pour adresser des données, enregistrées dans une mémoire (SE) et représentatives des caractéristiques des topologies de circuits électriques et des caractéristiques électriques des différents circuits pour un schéma électrique donné à dimensionner à l'aide de l'outil (ODE).

4. Outil selon la revendication 3, **caractérisé en ce que** les moyens pour adresser des données dans une mémoire (SE) permettent aussi, lors de la première phase de dimensionnement en fonctionnement nominal de réaliser une étape (2) de détermination de la topologie de chaque circuit électrique (Ci) sur la base du fonctionnement des composants (Dip) du circuit (Ci), ainsi que des conducteurs (Fip), puis une boucle de calcul et de modifications (3, 4) qui se termine par un test de fin de boucle (5) qui permet de déterminer si la simulation du fonctionnement du circuit (Ci) en cours de test de première phase est correct ou non, le traitement étant réitéré pour chaque circuit (Ci) du schéma électrique.

5. Outil selon l'une quelconque des revendications précédentes, **caractérisé en ce que** le moteur de simulation (MD, SQ) comporte des moyens pour exécuter la seconde phase (11-23) de dimensionnement en vérification en court-circuit des composants des circuits du schéma électrique qui comporte :
- une première boucle de contrôle (11) qui pour chaque circuit (Ci) établit un dimensionnement en simulant le court-circuit ;
- une boucle (12) qui, pour chaque composant (Dik) du circuit (Ci), réalise la simulation du court-circuit du composant (Dik) ;
- une étape (14) qui, dans l'état de court-circuit du composant Dik, réalise le calcul d'une liste des courants de court-circuit qui traverse le composant (Dik) ;
- une étape (15) qui réalise la liste des conducteurs qui sont parcourus par les courants de la liste établie à l'aide de l'étape (14) ;
- une boucle (16) sur chacun des conducteurs listés dans la liste produite à l'aide de l'étape (15) de sorte que, pour chaque conducteur de cette liste, on effectue un test pour savoir si les paramètres de ce conducteur permettent de tenir les caractéristiques en courant du court-circuit ; si un défaut apparait dans le test, lors de la sous étape (19), on compare le courant qui traverse le fil (Fik) avec le courant ou le paramètre de claquage du de déclenchement du dispositif de protection Pi qui lui est associé;
et **en ce que** on réalise la modification des paramètres du conducteur en défaut jusqu'à permettre le dimensionnement convenable du conducteur.

6. Outil selon l'une quelconque des revendications précédentes, **caractérisé en ce que** le moteur de simulation (MD, SQ) comporte des moyens pour exécuter la troisième phase de dimensionnement en vérification du respect de la chute de tension au cours de laquelle est effectuée une boucle de vérification de contraintes de tension minimale pour chaque circuit (Ci), pour chaque circuit une seconde boucle (25) pour chacun des composants (Dik) du circuit Ci de sorte que :
lors d'une étape (26), on réalise le calcul de la tension minimale d'alimentation du composant (Dik) en cours d'analyse ;
lors d'une étape (27), on réalise la liste des conducteurs qui parviennent au composant (Dik) ;
lors d'une étape (28), on réalise ensuite le tri de cette liste de conducteur par section de fils croissants, puis par longueur de conducteurs décroissantes;
lors d'une étape (29), on initie une boucle sur la liste triée, de sorte que pour chaque conducteur de cette liste,
lors d'une étape (30), on réalise le calcul de la chute de tension que ce conducteur apporte ;
puis, on réalise le test pour savoir si la tension minimum d'alimentation sur le composant est garantie avec la chute de tension calculée lors de l'étape (30), de sorte que le cas échéant, lors d'une étape (33), on réalise une modification des paramètres du conducteur destinée à réduire d'un pas déterminé la chute de tension qu'il introduit.

7. Outil selon l'une quelconque des revendications précédentes, **caractérisé en ce que** le dispositif d'entrée (IU) de l'outil de dimensionnement (ODE) comporte une ou plusieurs consoles connectées sur un réseau de communications (RL) et comportant un ensemble composé d'un clavier, d'un périphérique de pointage et d'un écran.

8. Outil selon la revendication précédente, **caractérisé en ce que** le moteur de simulation (MS) comporte des moyens pour modifier des données de la base de données initiales (BDl) en fonction de l'exécution du procédé de façon à générer un fichier de résultats de simulation du schéma électrique (FRS) qui est stocké dans une mémoire sous une structure déterminée permettant de classer les différentes données.

9. Outil selon la revendication précédente, **caractérisé en ce que** le dispositif de sortie (DS) comporte des moyens pour produire un fichier de résultats de dimensionnement final (FRD).

10. Outil selon la revendication précédente, **caractérisé en ce que** le fichier de résultats de dimensionnement (FRD) comporte une liste de sections de conducteurs et de calibres des fusibles des circuits électriques du schéma électrique d'entrée.

11. Outil selon une des revendications 9 ou 10, **caractérisé en ce que** le dispositif de sortie (DS) comporte un dispositif d'exploitation du fichier de résultat de simulation du schéma électrique et un dispositif de proposition de calcul à un utilisateur, le dispositif d'exploitation du fichier de résultat de simulation du schéma électrique comportant une ressource de lecture des articles du fichier de résultats de simulation du schéma électrique en fonction de requêtes du dispositif de proposition de calcul à un utilisateur.

12. Outil selon la revendication précédente, **caractérisé en ce que** le dispositif de proposition de calcul à un utilisateur comporte une interface utilisateur qui permet à l'utilisateur d'effectuer les différents calculs selon les régles de métier qu'il prend en compte de façon à produire le fichier de résultats de dimensionnement.

13. Outil selon la revendication précédente, **caractérisé en ce que** tout ou partie du travail du moteur de dimensionnement (DS) est automatisé sur la base d'un système expert intégrant les règles de métier que l'utilisateur prend en compte dans la version « manuelle ».

14. Outil selon la revendication précédente, **caractérisé en ce que** le dispositif de sortie (DS) comporte un moyen de rétro annotation (RA) qui retourne des données de dimensionnement intermédiaire des conducteurs et des calibres d'au moins un circuit électrique du schéma électrique à destination de l'application logicielle et du poste de travail (PdTi) sur un réseau de communications qui a produit ou qui est en train de concevoir le circuit électrique (Ci).

15. Procédé de dimensionnement électrique d'un schéma électrique comportant au moins une source électrique et au moins un circuit électrique (Ci) de composants (Dik) reliés par des conducteurs (Fik) et, le cas échéant, protégés par des dispositifs de protection électrique (Di), **caractérisé en ce qu'**il consiste à réaliser un dimensionnement des paramètres des conducteurs et des calibres des dispositifs de protection des circuits électriques (Ci) du schéma en cours de dimensionnement sur la base de contraintes électriques imposées successivement selon les phases suivantes :
- un dimensionnement en fonctionnement nominal du schéma électrique (Figure 2) ;
- un dimensionnement en vérification en court-circuit des composants des circuits du schéma électrique (Figure 4) ;
- un dimensionnement en test du respect de conditions de fonctionnement en chute de tension (Figure 5), et
- une phase d'enregistrement, sur un dispositif lisible par un ordinateur, du dimensionnement ainsi obtenu des paramètres des conducteurs et des calibres des dispositifs de protection des circuits électriques (Ci) du schéma en cours de dimensionnement.

16. Procédé selon la revendication 15, **caractérisé en ce que** la première phase comporte une séquence d'initialisation (1) préalable de migration des données caractéristiques des circuits électriques calculées lors de la conception du schéma électrique et qui est complétée par des opérations suivantes :
• Recherche des données et modèles manquants ;
• Recherche de la topologie de chaque circuit électrique du schéma;
• Acquisition des données manquantes;
• Acquisition des paramètres de dimensionnement.

17. Procédé selon l'une quelconque des revendications 15 ou 16, **caractérisé en ce que** la première phase de dimensionnement en fonctionnement nominal comporte une étape (2) de détermination de la topologie de chaque circuit électrique (Ci) sur la base du fonctionnement des composants (Dip) du circuit (Ci), ainsi que des conducteurs (Fip) puis une boucle de calcul et de modifications (3, 4) qui se termine par un test de fin de boucle (5) qui permet de déterminer si la simulation du fonctionnement du circuit (Ci) en cours de test de première phase est correct ou non, le traitement étant réitéré pour chaque circuit (Ci) du schéma électrique.

18. Procédé selon l'une quelconque des revendications 15 à 17, **caractérisé en ce que** la seconde phase (11-23) de dimensionnement en vérification en court-circuit des composants des circuits du schéma électrique comporte :
- une première boucle de contrôle (11) qui pour chaque circuit (Ci) établit un dimensionnement en simulant le court-circuit ;
- une boucle (12) qui, pour chaque composant (Dik) du circuit (Ci), réalise la simulation du court-circuit du composant (Dik) ;
- une étape (14) qui, dans l'état de court-circuit du composant Dik, réalise le calcul d'une liste des courants de court-circuit qui traverse le composant (Dik) ;
- une étape (15) qui réalise la liste des conducteurs qui sont parcourus par les courants de la liste établie à l'aide de l'étape (14) ;
- une boucle (16) sur chacun des conducteurs listés dans la liste produite à l'aide de l'étape (15) de sorte que, pour chaque conducteur de cette liste, on effectue un test pour savoir si les paramètres de ce conducteur permettent de tenir les caractéristiques en courant du court-circuit ; si un défaut apparaît dans le test, lors de la sous étape (19), on compare le courant qui traverse le fil (Fik) avec le courant ou le paramètre de claquage ou de déclenchement du dispositif de protection Pi qui lui est associé ;
et **en ce que** on réalise la modification des paramètres du conducteur en défaut jusqu'à permettre le dimensionnement convenable du conducteur.

19. Procédé selon l'une quelconque des revendications 15 à 18, **caractérisé en ce que** la troisième phase de dimensionnement en vérification du respect de la chute de tension effectue une boucle de vérification de contraintes de tension minimale pour chaque circuit (Ci), pour chaque circuit une seconde boucle (25) pour chacun des composants (Dik) du circuit Ci de sorte que :
lors d'une étape (26), on réalise le calcul de la tension minimale d'alimentation du composant (Dik) en cours d'analyse;
lors d'une étape (27), on réalise la liste des conducteurs qui parviennent au composant (Dik) ;
lors d'une étape (28), on réalise ensuite le tri de cette liste de conducteur par section de fils croissants, puis par longueur de conducteurs décroissantes;
lors d'une étape (29), on initie une boucle sur la liste triée, de sorte que pour chaque conducteur de cette liste,
lors d'une étape (30), on réalise le calcul de la chute de tension que ce conducteur apporte ;
puis, on réalise le test pour savoir si la tension minimum d'alimentation sur le composant est garantie avec la chute de tension calculée lors de l'étape (30), de sorte que le cas échéant, lors d'une étape (33), on réalise une modification des paramètres du conducteur destinée à réduire d'un pas déterminé la chute de tension qu'il introduit.

20. Un article de commerce comportant une mémoire lisible par un ordinateur, un programme exécutable par un ordinateur étant enregistré sur ladite mémoire pour le de dimensionnement électrique d'un schéma électrique, ledit schéma comportant au moins une source électrique et au moins un circuit électrique (Ci) de composants (Dik) reliés par des conducteurs (Fik) et, le cas échéant, protégés par des dispositifs de protection électrique (Di), **caractérisé en ce que** ledit programme inclut un codage pour réaliser un dimensionnement des paramètres des conducteurs et des calibres des dispositifs de protection des circuits électriques (Ci) du schéma en cours de dimensionnement sur la base de contraintes électriques imposées successivement selon les phases suivantes:
- un dimensionnement en fonctionnement nominal du schéma électrique (Figure 2) ;
- un dimensionnement en vérification en court-circuit des composants des circuits du schéma électrique (Figure 4) ;
- un dimensionnement en test du respect de conditions de fonctionnement en chute de tension (Figure 5), et
- une phase d'enregistrement, de préférence sur un dispositif lisible par un ordinateur, du dimensionnement ainsi obtenu des paramètres des conducteurs et des calibres des dispositifs de protection des circuits électriques (Ci) du schéma en cours de dimensionnement.
